(19) Europäisches Patentamt
European Patent Office
Office européen des brevets

(11) **EP 4 664 128 A1**

(12) **EUROPEAN PATENT APPLICATION**

(43) Date of publication:
**17.12.2025 Bulletin 2025/51**

(21) Application number: **24182067.9**

(22) Date of filing: **13.06.2024**

(51) International Patent Classification (IPC):
***G01R 31/367*** (2019.01)     ***G01R 31/389*** (2019.01)
***G01R 31/392*** (2019.01)

(52) Cooperative Patent Classification (CPC):
**G01R 31/389; G01R 31/367; G01R 31/392**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **TOYOTA JIDOSHA KABUSHIKI
KAISHA
Aichi-ken, 471-8571 (JP)**

(72) Inventors:
• **SYMEONIDIS, Nikos
1140 BRUSSELS (BE)**
• **LE LOUVETEL-POILLY, Julie
1140 BRUSSELS (BE)**

(74) Representative: **Cabinet Beau de Loménie
103, rue de Grenelle
75340 Paris Cedex 07 (FR)**

(54) **METHOD AND SYSTEM FOR ESTIMATING RECHARGEABLE BATTERY'S INTERNAL
RESISTANCE VALUE**

(57)     A computer-implemented method for estimating a value of a rechargeable battery's internal resistance at a stage of the battery's test. The method includes calculating the value of the internal resistance at the stage, equivalent to an average of one or more resistance values. Each of the one or more resistance values is obtained by dividing an absolute difference between an initial voltage of the battery at a start moment of one of one or more time steps at least partially representing the stage and an end voltage of the battery at an end moment of the time step by an absolute difference between an initial current of the battery at the start moment of the time step and an end current of the battery at the end moment of the time step. The test includes one or more cycles for simulating a degradation process of the battery under a predefined usage condition. Each of the one or more cycles includes a discharge phase of depleting energy of the battery according to a test profile and a charge phase of charging the battery. The discharge phase of one of the one or more cycles includes the one or more time steps.

FIG. 1A

**Description**

BACKGROUND OF THE INVENTION

1. Field of the invention

The present disclosure relates to the technical filed of battery aging evaluation, and in particular, to a computer-implemented method for estimating a rechargeable battery's internal resistance value, a computing system, a computer program product and a computer readable storage medium.

2. Description of Related Art

The new Euro 7 standards will regulate the durability of batteries installed in cars and vans, aiming to increase consumer confidence in electric vehicles (hereinafter "EVs"). This will also reduce the need for replacing batteries early in the life of a vehicle, thus reducing the demand for new critical raw materials needed for battery production. EV battery durability refers to a battery's ability to withstand degradation of functionality such that it meets power and energy performance targets during typical drive cycles, consumer usage, and storage conditions without exceeding its end-of-life cycle and calendar life specifications [1].

Cycle life test is a type of durability test. In general, a cycle life test includes cycles each including a discharge phase of performing a designated test profile at a desired test temperature until the net energy is equal to a specified available energy target, an open circuit phase of resting the battery at open-circuit voltage (hereinafter "OCV") for a default period, and a charge phase of fully charging the battery using the manufacturer recommended procedure. The cycles are repeated continuously without interruption for a specified number of times or for a specified period of time. The test profile may be a variable power discharge regime, which is designed to simulate the effects of EV driving behaviors (usually including regenerative braking) on battery performance and lifespan. A typical example of cycle life tests is the cycle life Dynamic Stress Test (hereinafter "DST") defined in Chapter 3.9 of Reference [2].

Globally recognized standard variable power discharge regimes correspond to standard driving cycles (also referred to as "driving schedule" or "drive schedule") that can be divided into three groups: European driving cycles, US driving cycles and Asian (Japanese, Chinese -Beijing) driving cycles. For example, the Urban Dynamometer Driving Schedule (hereinafter "UDDS") is commonly used for "city- based EV driving cycle tests" representing light-duty city driving conditions. US06 represents an aggressive driving cycle with high engine loads. The European drive cycle ARTEMIS contains 12 driving cycles that range across several driving conditions: congested urban, free-flow urban, secondary roads, main roads and motorways. The Highway Fuel Economy Driving Schedule (hereinafter "HWFET") is used to describe cars cruising under 60mph on a highway. And, the Air Resources Board LA92 dynamometer driving profile was developed to depict a driving cycle with higher top and average speed, lower idle time, fewer stops per mile and a higher maximum rate of acceleration when compared with UDDS. United States Advanced Battery Consortium (hereinafter "USABC") defined variable power discharge regimes include Dynamic Stress Test (hereinafter "DST") and Federal Urban Driving Schedule (hereinafter "FUDS").

The state of health (hereinafter "SOH") of an EV battery, which provides information on the life span of the battery, is one of the most important indices for ensuring safety and efficiency of use. Although SOH is not a strictly defined physical quantity, the battery internal resistance is commonly accepted as a critical indicator to estimate the battery SOH level. The internal resistance of the battery is heavily impacted by aging and degradation. Its value increases when the battery SOH decreases.

To estimate the SOH level of a battery, reference performance tests (hereinafter "RPTs") need to be conducted as periodic interruptions during cycle life testing to gather data from which the present internal resistance of the battery can be determined. For example, as specified in step 6 of Section 3.9.1 of Reference [1], after the specified number or time period of repetitions of DST cycles, cycling is suspended to perform RPT tests to determine the extent of degradation in power capability, which is governed by the battery internal resistance.

However, it is not practical to perform RPTs frequently because they are time-consuming and expensive. Moreover, the battery undergoes unnecessary degradation during test operations. Therefore, the RPTs should be performed as infrequently as possible.

SUMMARY

The object of the present invention is to at least substantially remedy the above-mentioned problem. Unless otherwise stated, each of the words "example", "embodiment", and "option" is used herein to refer to one or more optional features provided in some embodiments and not provided in other embodiments. Any particular embodiment of the invention may include a plurality of such features unless such features conflict. The scope of the present invention is defined by the appended claims. Unless otherwise stated, all aspects, examples, and embodiments described herein are compatible with each other.

A first aspect of the present disclosure relates to a method for estimating the value of a rechargeable battery's internal resistance at a stage of the battery's test. The method is implemented by a computing system, and includes a step of calculating the value of the internal resistance at the stage, which is equivalent to the average of one or more resistance values. Each of the one or more resistance values equals to the quotient of the absolute value of the difference between an initial voltage of the battery at the start moment of one of one or more time steps at least partially representing the stage and an end voltage of the battery at the end moment of the time step divided by the absolute value of the difference between an initial current of the battery at the start moment of the time step and an end current of the battery at the end moment of the time step.

As used herein, the term "voltage of the battery" refers to the difference in electrical potential between the positive and negative terminals of the battery. The term "current of the battery" refers to the current flowing from the positive terminal to the negative terminal of the battery. The above-mentioned initial voltage(s), end voltage(s), initial current(s), and end current(s) of the battery may be measured by the computing system by using one or more sensors. They may be denoised signals, where the denoising may be performed by the one or more sensors or by the computing system.

The test includes one or more cycles for simulating a degradation process of the battery under a predefined usage condition. The cycles may be consecutive. Each of the one or more cycles includes a discharge phase of depleting energy of the battery according to a test profile and a charge phase of charging the battery. The discharge phase of one of the one or more cycles includes the one or more time steps, which may be consecutive and represent the stage.

As an example, the usage condition may include driving condition(s) when the battery is a vehicle battery. Further, the test profile may correspond to a standard driving cycle/schedule. Still further, the test file may indicate a level of peak discharge power at each of different sub-phases of the discharge phase. As is known in the art, the level of peak discharge power may be represented in percentage or in unit such as W/kg, and its value may be positive, which indicates that energy is removed from the battery rather than supplied to it, or may be negative, which indicates that regenerative (vehicle kinetic) energy (typically from braking) is supplied to the battery. Still further, the test file may be the same for the cycles.

As used herein, the term "one or more cycles for simulating a degradation process of the battery under a predefined usage condition" means that the one or more cycles are suitable for simulating the degradation process. For example, cycles each including a discharge phase of performing a test profile corresponding to a globally-recognized driving cycle are suitable for simulating such a degradation process, whether or not the cycles are designed for this purpose.

As used herein, the expression "consecutive cycles/time steps" means that the cycles or time steps follow one after the other without any interruptions. Said stage may correspond to a target value reached by the battery's state-of-charge (hereinafter "SOC") after the test has been conducted for a particular period of time or after a particular number of the above type of cycles have been conducted. For instance, the stage may be one where an RPT is performed to estimate the battery internal resistance in existing technology. Note that the terminology "SOC" has a well-recognized meaning in the art. For example, the same definition is given in reference [2] on page x of "GLOSSARY" and in reference [3] on page F-10. This definition applies as used herein.

As is known in the art, RPT tests, such as peak power tests or a hybrid pulse power characterization (hereinafter "HPPC") tests, do not include the one or more cycles as described above. Also, no RPT test will be included in such a cycle or cycles. By contrast, the cycling procedures of existing cycle life tests include such one or more cycles. As described earlier herein, in the existing technology, RPT tests are performed between two cycling procedures of a cycle life test.

As such, according to the first aspect of the present disclosure, the battery internal resistance is calculated based on voltage and current data collected from a cycling procedure simulating the battery degradation process under a predefined usage condition, thereby reducing the number of RPT tests (or any other similar type of tests, e.g., if the battery is not a vehicle battery) required to estimate the battery SOH at different stages of the degradation process. Accordingly, the method reduces the cost and duration of battery tests and avoids unnecessary degradation of the battery. In particular, experiments conducted by the inventors have shown that the method above obtains accurate results compared to traditional RPT tests and can replace at least two-thirds of the RPT tests performed in an aging campaign.

In an example of the first aspect, the voltage of the battery at the start of the discharge phase of each of the one or more cycles is higher than the voltage of the battery at the end of the discharge phase. The voltage of the battery at the start of the charge phase of each of the one or more cycles is lower than the voltage of the battery at the end of the charge phase. Further, each of the one or more cycles may include only one such charge phase or only one such discharge phase, or, each of the one or more cycles may include an open-circuit phase of resting the battery at open-circuit conditions that immediately follows the charge phase and immediately precedes the discharge phase.

In still another example of the first aspect, the test further includes an open-circuit phase immediately preceding the discharge phase including the one or more time steps. Since the battery rests at open-circuit conditions prior to this discharge phase, the SOC value of the battery at the start moment of this discharge phase can be estimated using an open-circuit voltage (hereinafter "OCV")-SOC map. Accordingly, the method further includes a step of estimating the SOC value of the battery at the start moment of the discharge phase including the one or more time steps based on the voltage of the battery at said start moment of the discharge phase. The SOC value may be determined further based on an OCV-SOC map, which may be one that shows correspondence relationships between the OCV values and SOC values of the battery when the SOH of the batter is 100%. Such an OCV-SOC map is usually provided by the battery manufacturer. The method further includes using the estimated SOC value as an initial SOC value of the battery to determine one or more moments included in the one or more time steps based on a target SOC value corresponding to the stage.

In still another example of the first aspect that is compatible with the example above, the step of determining the one or more moments includes a sub-step of determining both the sum of the target SOC value and a margin and the result of the target SOC value minus the margin, and a sub-step of determining a moment in the discharge phase where the battery's SOC value reaches the sum and a moment in the discharge phase where the battery's SOC value reaches the result as the start moment of the first one of the time steps and the end moment of the last one of the time steps, respectively. The margin indicates the difference between SOC values (e.g., between the target value, which is a midpoint value, and each of the two boundary values). An example of the margin is 1%.

In particular, the following formula may be used to determine the one or more moments of the one or more time steps:

$$SOC(t) = SOC(0) - \frac{1}{Q} \int_0^t \eta(\tau) \cdot i_{mean}(\tau) \cdot d\tau, \ (1)$$

where $SOC(0)$ is the initial SOC value, $SOC(t)$ is the target SOC value, $\eta$ is the coulomb efficiency, Q is the nominal capacity, and $i_{mean}(\tau)$ is the measured current of the battery at moment $\tau$.

As such, this example can identify one or more consecutive time steps representing the stage in the discharge phase. In still another example of the first aspect, which enhances the estimation accuracy of the battery internal resistance, prior to calculating the value of the internal resistance at the stage of the test, the method further includes a step of determining whether the absolute value of the difference between the initial current of the battery at the start moment of the one or more consecutive time steps representing the stage and the end current of the battery at the end moment of the time step is greater than a minimum value determined based on a battery current measurement equipment tolerance. If the absolute value of the difference is smaller than or equal to the minimum value, then the initial and end voltages and initial and end currents of the battery in the time step are not taken into account when calculating the value of the internal resistance at the stage, and vice versa. Or alternatively, if the absolute value of the difference is smaller than or equal to the minimum value, calculation of the value of the internal resistance at the stage is not performed, and if the absolute value of the difference for each of the one or more consecutive time steps is greater than the minimum value, the calculation step is performed based on the initial and end voltages and initial and end currents of the battery in each of the one or more time steps. The latter option could further enhance the estimation accuracy of the battery internal resistance.

In still another example of the first aspect, the duration of each of the one or more time steps equals the reciprocal of the sampling rate of one or more sensors measuring the current of the battery during the time step. The duration may be the same for the time step(s).

Or, the duration is smaller than or equal to 0.1 second. It is estimated that for such duration, the difference between OCVs can be neglected, thereby improving the accuracy of estimating the battery internal resistance compared to the internal resistance estimated from pulse currents in existing RPTs.

In still another example of the first aspect, the method further includes a step of multiplying the value of the internal resistance by a temperature correction factor to estimate a value of the internal resistance of the battery when the battery has a first temperature different from the average temperature of the battery, has the target SOC value, and has the same SOH level as at the stage of the test. This SOH level is herein referred to as a first SOH level. The temperature correction factor may be pre-stored in the computing system or received from another computing device.

This example facilitates estimation of the battery internal resistance value at a different temperature without conducting another test, thereby enhancing the estimation efficiency.

In addition, the method may further include a step of measuring temperatures of the battery during the one or more cycles of the test via a sensor, and a step of determining the average temperature based on the measured temperatures.

In still another example of the first aspect that is compatible with the example above, the temperature correction factor is an estimate or an equivalent of the ratio of the internal resistance value when the battery has the first temperature, the target SOC value, and a given SOH level to the internal resistance value when the battery has the average temperature, the target SOC value and the given SOH level. The given SOH level may be the same or different from the first SOH level.

The temperature correction factor may be provided by the battery manufacturer or predetermined by the computing system or another computing device. For instance, the given SOH level may be 100%. If temperature correction factors associated with the target SOC value and different SOH levels are provided by the battery manufacturer or predetermined, the method may further include a step of estimating the SOH level of the battery at the stage of the test based on the calculated value of the battery internal resistance at the stage, and a step of determining the temperature correction factor based on the estimated SOH level, the target SOC, the first temperature and the average temperature. The SOH level may be estimated by using any existing method, and the given SOH level with which the temperature correction factor is associated may be one that most closely approximates the estimated SOH level among the different SOH levels.

In still another example that is compatible with the two examples above, when the average temperature of the battery is lower than or equals to 25°C, the first temperature is higher than -15°C. Or, when the average temperature of the battery is lower than or equals to 45 °C, the first temperature is higher than -5 °C. Or, when the average temperature of the battery is lower than or equals to 60°C, the first temperature is higher than 7 °C. These ranges will enhance the estimation accuracy according to the inventor's experiment results.

A second aspect of the present disclosure relates to a computer program product for executing the steps of the method of the first aspect when said program set is executed by at least one computer.

This computer program can use any programming language and take the form of source code, object code or a code intermediate between source code and object code, such as a partially compiled form, or any other desirable form.

A third aspect of the present disclosure relates to a computer-readable information medium containing instructions of a computer program product as described above. In particular, the information medium may be non-transitory.

The information medium can be any entity or device capable of storing the computer program. For example, the medium can include storage means such as a ROM, for example a CD ROM or a microelectronic circuit ROM, or magnetic storage means, for example a diskette (floppy disk) or a hard disk.

Alternatively, the information medium can be an integrated circuit in which the computer program is incorporated, the circuit being adapted to execute the method in question or to be used in its execution.

A fourth aspect of the present disclosure relates to a computing system, which includes one or more processors and one or more memories storing the computer program product of the second aspect.

BRIEF DESCRIPTION OF THE DRAWINGS

Features, advantages, and technical and industrial significance of exemplary embodiments of the invention will be described below with reference to the accompanying drawings, in which like signs denote like elements, and wherein:

- FIG. 1A is a flow chart of a method for estimating the value of a rechargeable battery's internal resistance at a stage of the battery's test according to an example of a first embodiment;
- FIG. 1B illustrates different examples of the stage;
- FIG.2 is a flow chart of the method according to another example of the first embodiment;
- FIG. 3 is a schematic diagram of a computing system according to a second embodiment.

DETAILED DESCRIPTION OF EMBODIMENTS

Various aspects of the disclosure are illustrated below through specific exemplary embodiments. The flowcharts or block diagrams in the figures illustrate the configuration, operations and functionality of possible implementations of devices, methods and computer program products according to various embodiments of the present disclosure. In this regard, each block in the flowcharts or block diagrams may indicate a module, segment, or portion of code, which includes one or more executable instructions for implementing the specified logical function(s).

In a first exemplary embodiment, a method for estimating the value of a rechargeable battery's internal resistance at a stage of the battery's test is provided. The test includes cycles for simulating a degradation process of the battery under a predefined usage condition. Each of the cycles includes a discharge phase of depleting energy of the battery according to a test profile and a charge phase of charging the battery. Depending on the test profile, a variable current may be imposed on the battery during the discharge phase of each of the cycles. The stage corresponds to a target value reached by the battery's SOC after a particular event, which is determined according to the expected aging condition to be simulated. The particular event may be that the test has been conducted for a particular period of time or that a particular number of the above type of cycles have been conducted (with or without interruptions between the cycles). The stage is represented by consecutive time steps in the discharge phase of one of consecutive cycles immediately following the particular event. In particular, the cycle may be the first one of the consecutive cycles.

In this specific example, the stage is one of those where an RPT is performed to estimate the battery internal resistance in existing technology.

The method may be implemented by a computing system communicatively connected to a voltage sensor, a current sensor, and a temperature sensor respectively reporting to the computing system raw data representing the voltages of the battery, raw data representing the currents of the battery, and temperatures of the battery. The computing system may be configured to pre-process the raw data (e.g., by removing noise therein) to measure/obtain the voltage and current of the battery.

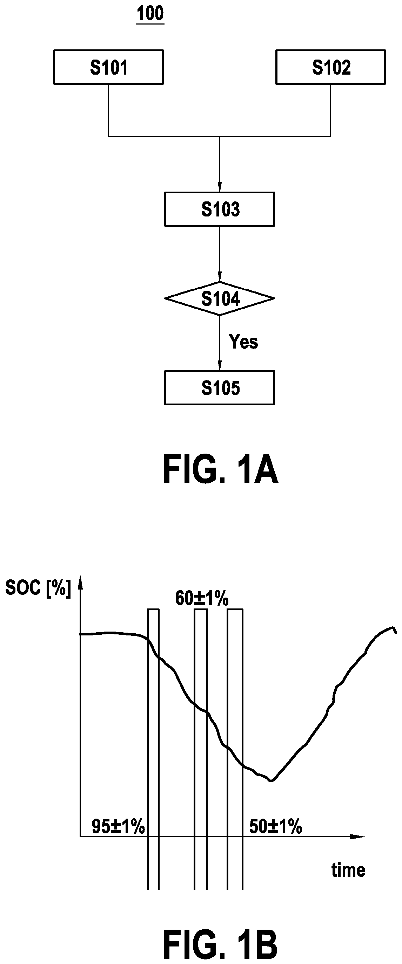

As illustrated by Fig. 1A, the method 100 includes a step S101 of determining both the sum of the target SOC value and a margin and the result of the target SOC value minus the margin, a step S102 of estimating the SOC value of the battery at the start moment of the discharge phase based on the battery voltage at the start moment of the discharge phase including the consecutive time steps and an OCV-SOC map, and a step S103 of using the estimated SOC value as an initial SOC value of the battery to determine a moment $t_s$ in the discharge phase where the battery's SOC value reaches the sum and a moment $t_e$ in the discharge phase where the battery's SOC value reaches the result as the start moment of the first one of the consecutive time steps and the end moment of the last one of the consecutive time steps, respectively. In this example, the margin is 1%. The target value of the SOC may be set at 50%, 60%, or 95%. The different examples of the stage are illustrated by Fig. 1B.

In particular, the following formula (1) is used to determine the start moment $t_s$ and end moment $t_e$ of the consecutive time steps:

$$SOC(t) = SOC(0) - \frac{1}{Q} \int_0^t \eta(\tau) \cdot i_{mean}(\tau) \cdot d\tau, \quad (1)$$

where $SOC(0)$ is the initial SOC value, $SOC(t)$ is the target SOC value, $\eta$ is the coulomb efficiency, Q is the nominal capacity, and $i_{mean}(\tau)$ is the current of the battery at moment $\tau$.

The method 100 further includes a step S104 of determining whether the absolute difference between the initial current of the battery at the start moment of one of the consecutive time steps and the end current of the battery at the end moment of the time step is greater than a minimum value determined based on a battery current measurement equipment tolerance. In this example, the minimum value is 10A and the duration of each time step is 0.1s.

If the absolute difference is not greater than the minimum value, then the method 100 does not estimate the value of the battery's internal resistance at this stage. Otherwise the method 100 proceeds to step S105 of calculating the value of the internal resistance at the stage. The value equals to the average of resistance values R0, each of which is equivalent to the quotient of the absolute difference between an initial voltage V[t] of the battery at the start moment of one of the consecutive time steps and an end voltage $V[t + \Delta t]$ of the battery at the end moment of the time step by the absolute difference between an initial current $i[t]$ of the battery at the start moment of the time step and an end current $i[t + \Delta t]$ of the battery at the end moment of the time step.

Each of the resistance values R0 may be calculated by using the following formula (3):

$$R0 = \left| \frac{V[t+\Delta t] - V[t]}{i[t+\Delta t] - i[t]} \right|, \quad (3)$$

where $\Delta t = 0.1$s.

Consecutive cycles of the test may be conducted in an environment where the temperature is strictly controlled. In this example, the temperature of consecutive cycles including the consecutive time steps is 60°C or 45 °C. The method 100 may use the battery internal resistance value calculated at step S105 to estimate the internal resistance value of the battery when the battery has a first temperature different than the average temperature of the battery in the consecutive cycles, has the target SOC value, and has the same SOH level as at the stage of the test. For example, the first temperature may be 26°C, 3°C, -7°C, or -32 °C.

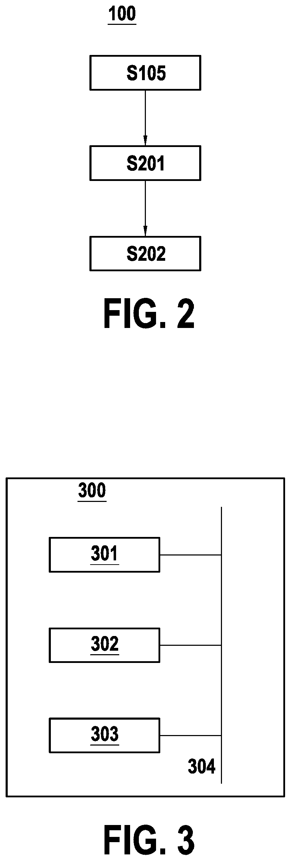

Specifically, as illustrated by Fig. 2, the method 100 further includes a step of S201 of determining the mean $T_a$ of the temperatures of the battery during the consecutive cycles including the consecutive time steps, and a step S202 of multiplying the internal resistance value $\overline{R0}_{SOH,T_a,SOC}$ calculated at step S105 by a temperature correction factor $K_T$ to estimate the internal resistance value $R0_{SOH,T_1,SOC}$ of the battery at the first temperature $T_1$.

In other words, the internal resistance value of the battery at the first temperature is calculated using the formula (4) below:

$$R0_{SOH,T_1,SOC} = \overline{R0}_{SOH,T_a,SOC} \cdot K_T, \quad (4)$$

where $K_T$ represents the ratio of the internal resistance value of the battery when the battery has the first temperature, the target SOC value and a given SOH level to the internal resistance value of the battery when the battery has the average temperature, the target SOC value and the given SOH level. In this particular example, $K_T$ is provided by the battery manufacturer, where the given SOH level is 100%.

Moreover, when $T_a \leq 25°C$, $T_1 \geq -20°C$; when $25°C \leq T_a \leq 45°C$, $T_1 \geq -5°C$; and when $45°C \leq T_a \leq 60°C$, $T_1 \geq -7°C$.

As an example, the test profile may correspond to either LA#4 or US06.This ensures that the estimation error is limited to within 10% compared to RPT test results according to experiments conducted by the inventors, which is linked with the smaller effect of the temperature correction factor.

The above-described method is applicable to batteries of electrified vehicles (hereinafter "xEVs"), which includes battery electric vehicles (hereinafter "BEVs") along with hybrid electric vehicles (hereinafter "HEVs") and subset thereof. It is also applicable to any other type of suitable batteries. In addition, the battery may include battery cells connected in series or in series-parallel that are treated as a single battery, or the battery may include a single battery cell. The battery cell(s) each may be a lithium ion cell, a nickel hydrogen cell, a lead cell, a double layer electric capacitor, or any other type of suitable cell.

Fig. 3 illustrates a computing system 300 according to a second exemplary embodiment of the disclosure. The computing system 300 is configured to implement the method according to the first exemplary embodiment. The system 300 may include one or more computing devices each including one or more processors 301 and one or more storage media 302 storing instructions which, when executed by the one or more processors 301, cause the one or more processors 301 to implement the method according to the first embodiment. The one or more computing devices may further include one or more transceivers 303 to communicate with a voltage sensor, a current sensor, and/or a temperature sensor under the control of the one or more processors 301.

Each of the one or more computing devices may be a high-performance computer, a server, a user device (e.g., a laptop computer, a home desktop computer, a mobile device such as a tablet, a smartphone, a wearable device, etc.), an embedded device (e.g., a device embedded within a vehicle, a household appliance, a sensor, etc.), a platform having one or more corresponding application programming interfaces (hereinafter "APIs"), a cloud infrastructure, or any other computing device suitable for implementing one or more steps of the method according to the first embodiment.

Examples of the one or more processors 301 include a central processing unit (hereinafter "CPU"), a vision processing unit (hereinafter "VPU"), a graphics processing unit (hereinafter "GPU"), a tensor processing unit (hereinafter "TPU"), a neural processing unit (hereinafter "NPU"), a neural processing engine, a core of a CPU, VPU, GPU, TPU, NPU, or another processing device, an application processor, a display controller, an application-specific integrated circuit (hereinafter "ASIC"), a field-programmable gate array (hereinafter "FPGA"), a coprocessor, or any other hardware configured to function as a processor.

Examples of the one or more computer-readable storage media 302 include any available storage medium that can be accessed by the one or more processors 301 in the form of volatile or non-volatile memory. For instance, the storage medium may be a random access memory (hereinafter "RAM"), a dynamic random access memory (hereinafter "DRAM"), a static random access memory (hereinafter "SRAM"), any other form of volatile memory known in the art, a magnetic hard disk, an optical disk, a floppy disk, a flash memory, an electrically programmable read-only memory (hereinafter "EPROM"), an electrically erasable programmable read-only memory (hereinafter "EEPROM"), any other form of non-volatile memory known in the art, a data server, etc.

As shown by FIG. 3, the processor(s) 301, one or more storage media 302, and transceiver(s) 303 may be directly or indirectly coupled to each other physically, communicatively, or operationally via a communication channel 304. The communication channel 304 may include one or more buses (such as an address bus, data bus, or a combination thereof), a network connection, an inter-process communication data structure, or any other means for communicating data.

Although the present disclosure refers to specific exemplary embodiments, modifications may be provided to these examples without departing from the general scope of the invention as defined by the claims. In particular, individual characteristics of the different illustrated/mentioned embodiments may be combined in additional embodiments. Therefore, the description and the drawings should be considered in an illustrative rather than in a restrictive sense.

References:

[1] Cherry, Jeff. 2015. "Battery Durability in Electrified Vehicle Applications: A Review of Degradation Mechanisms and Durability Testing". United States. https://rechargebatteries.org/wp-content/uploads/2020/01/Report-EP-C-12-014-WA-3-01_rev2.pdf. (p. 21).

[2] Christophersen, Jon P. 2015. "Battery Test Manual For Electric Vehicles, Revision 3". United States. https://doi.org/10.2172/1186745.
https://www.osti.gov/servlets/purl/1186745.

[3] 1996. "USABC electric vehicle Battery Test Procedures Manual. Revision 2". United States. https://doi.org/10.2172/214312. https://www.osti.gov/servlets/purl/214312.

**Claims**

1. A computer-implemented method for estimating a value of a rechargeable battery's internal resistance at a stage of the battery's test, the method comprising:

   calculating(S105) the value ($\overline{R0}_{SOH,T_a,SOC}$) of the internal resistance at the stage, equivalent to an average of one or more resistance values (R0),
   wherein each of the one or more resistance values is obtained by dividing an absolute difference between an initial voltage (V[t]) of the battery at a start moment of one of one or more time steps at least partially representing the stage and an end voltage ($V[t + \Delta t]$) of the battery at an end moment of the time step by an absolute difference between an initial current (i[t]) of the battery at the start moment of the time step and an end current ($i[t + \Delta t]$) of the battery at the end moment of the time step,
   the test comprises one or more cycles for simulating a degradation process of the battery under a predefined usage condition,
   each of the one or more cycles comprises a discharge phase of depleting energy of the battery according to a test profile and a charge phase of charging the battery, and
   the discharge phase of one of the one or more cycles comprises the one or more time steps.

2. The method according to claim 1, further comprising:

   estimating (S102) a state-of-charge "SOC" value of the battery at a start moment of the discharge phase comprising the one or more time steps based on a voltage of the battery at said start moment of the discharge phase, said SOC value being determined as an initial SOC value of the battery; and
   determining one or more moments comprised in the one or more time steps based on the initial SOC value and a target SOC value corresponding to the stage, wherein the test further comprises an open-circuit phase of resting the battery at open-circuit conditions, and the discharge phase comprising the one or more time steps immediately follows the open-circuit phase.

3. The method according to claim 2, wherein determining the one or more moments comprises:

   determining (S101) a sum of the target SOC value and a margin, and a result of subtracting the margin from the target SOC value; and
   determining (S103) a moment in the discharge phase where the battery's SOC value reaches the sum and a moment in the discharge phase where the battery's SOC value reaches the result as the start moment ($t_s$) of a first one of the time steps and the end moment ($t_e$) of a last one of the time steps, respectively.

4. The method according to any one of the claims 1 to 3, further comprising:
   receiving, from one or more sensors, measurements related to the initial voltage and the initial current of the battery at the start moment of each of the one or more time steps, and measurements related to the end voltage and the end current of the battery at the end moment of the time step.

5. The method according to any one of the claims 1 to 4, wherein duration of each of the one or more time steps equals a reciprocal of a sampling rate of one or more sensors collecting the initial current or end current of each of the one or more times steps, or, the duration is smaller than or equal to 0.1 second.

6. The method according any one of the claims 1 to 5, further comprising:
   multiplying (S202) the value of the internal resistance by a temperature correction factor to estimate a value of the internal resistance of the battery at a first temperature different from an average temperature of the battery during the one or more cycles.

7. The method according claim 6, further comprising:

   receiving, from a sensor, measurements related to temperatures of the battery during the one or more cycles; and
   determining (S201) the average temperature based on the measurements.

8. The method according to any one of the claims 1 to 7, prior to the calculating step, further comprising:
   determining (S104) whether an absolute difference between the initial current and the end current of the battery in the one of the one or more time steps is greater than a minimum value determined based on a battery current measurement equipment tolerance, wherein the calculating step (S105) comprises:

calculating the value of the internal resistance at the stage based on the initial voltage, the end voltage, the initial current, and the end current of the battery in the time step in response to determining that the absolute difference between the initial current and the end current of the battery in the time step is greater than the minimum value.

9. A computer program set including instructions for executing the steps of the method of any one of claims 1 to 8 when said program set is executed by at least one computer.

10. A recording medium readable by at least one computer and having recorded thereon at least one computer program including instructions for executing the steps of the method of any one of claims 1 to 8.

11. A computing system (300), comprising:

one or more processors (301); and
one or more memories (302) storing the computer program set according to claim 9.

100

S101    S102

S103

S104

Yes

S105

# FIG. 1A

SOC [%]

60±1%

95±1%    50±1%

time

# FIG. 1B

<u>100</u>

```
┌──────────┐
│   S105   │
└──────────┘
     │
     ▼
┌──────────┐
│   S201   │
└──────────┘
     │
     ▼
┌──────────┐
│   S202   │
└──────────┘
```

# FIG. 2

<u>300</u>

```
┌─────────────┐
│  <u>301</u>     │────────┐
└─────────────┘        │
                       │
┌─────────────┐        │
│  <u>302</u>     │────────┤
└─────────────┘        │
                       │
┌─────────────┐        │
│  <u>303</u>     │────────┘
└─────────────┘
              304
```

# FIG. 3

| | Europäisches Patentamt<br>European Patent Office<br>Office européen des brevets | **EUROPEAN SEARCH REPORT** | **Application Number**<br>**EP 24 18 2067** |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | YIN LITAO ET AL: "Implementing intermittent current interruption into Li-ion cell modelling for improved battery diagnostics",<br>ELECTROCHIMICA ACTA, ELSEVIER, AMSTERDAM, NL,<br>vol. 427, 20 July 2022 (2022-07-20),<br>XP087146679,<br>ISSN: 0013-4686, DOI:<br>10.1016/J.ELECTACTA.2022.140888<br>[retrieved on 2022-07-20]<br>* the whole document *<br>----- | 1-11 | INV.<br>G01R31/367<br>G01R31/389<br>G01R31/392 |
| A | CN 116 626 506 B (LINQING POWER SUPPLY COMPANY STATE GRID SHANDONG ELECTRIC POWER COMPAN) 27 October 2023 (2023-10-27)<br>* the whole document *<br>----- | 1-11 | |
| A | BARRERAS JORGE VARELA ET AL: "Functional analysis of Battery Management Systems using multi-cell HIL simulator",<br>2015 TENTH INTERNATIONAL CONFERENCE ON ECOLOGICAL VEHICLES AND RENEWABLE ENERGIES (EVER), IEEE,<br>31 March 2015 (2015-03-31), pages 1-10,<br>XP032780590,<br>DOI: 10.1109/EVER.2015.7112984<br>[retrieved on 2015-05-26]<br>* the whole document *<br>----- | 1-11 | **TECHNICAL FIELDS SEARCHED (IPC)**<br><br>G01R |

The present search report has been drawn up for all claims

| Place of search | Date of completion of the search | Examiner |
|---|---|---|
| Munich | 12 November 2024 | O'Callaghan, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.............................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 2067

This annex lists the patent family members relating to the patent documents cited in  the above-mentioned European search report.
The members are as contained in the European Patent Office EDP file on
The European Patent Office is in no way liable for these particulars which are merely given for the purpose of information.

12-11-2024

| Patent document cited in search report | Publication date | Patent family member(s) | Publication date |
|---|---|---|---|
| CN 116626506 B | 27-10-2023 | NONE | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **CHERRY, JEFF.** Battery Durability in Electrified Vehicle Applications: A Review of Degradation Mechanisms and Durability Testing. *United States*, 2015
- **CHRISTOPHERSEN** ; **JON P**. Battery Test Manual For Electric Vehicles, Revision 3. *United States*, 2015, https://doi.org/10.2172/1186745

- USABC electric vehicle Battery Test Procedures Manual. Revision 2. *United States*, https://doi.org/10.2172/214312. https://www.osti.gov/servlets/purl/214312